# EUROPEAN PATENT APPLICATION

(11) **EP 1 577 979 A1**
(43) Date of publication of application: **21.09.2005**
(21) Application number: 05101799.4
(22) Date of filing: 08.03.2005
(51) Int. Cl.: H01R 12/32

(54) **Board through hole working method**

(30) Priority: 16.03.2004 JP 2004075155
(71) Applicant: Tyco Electronics AMP K.K., Kanagawa 213-8535 (JP)
(72) Inventor: Ikeda, Yuji, 213-8535, Kawasaki-shi (JP); Maruyama, Kiyomi, 213-8535, Kawasaki-shi (JP); Yamagami, Hidehisa, 213-8535, Kawasaki-shi (JP); Kawahara, Yuzo, 213-8535, Kawasaki-shi (JP)
(74) Representative: Johnstone, Douglas Ian

(57) **Abstract**

The object of the present invention is to provide a board through-hole working method which makes it possible to form in a circuit board a through-hole that does not strip metal plating away when a press-fit contact is inserted, with the amount of wear of a jig being minimized. The board through-hole working method is a board through-hole working method for working a through-hole (for the insertion of the press-fit contact 101) that is bored in a circuit board (PCB) and that is formed with a conductor (51). The method comprises a step of beveling the corner edge of a through-hole (50) following the formation of the conductor (51). This beveling is performed by the pressing of a pointed jig.

## Description

### BACKGROUND OF THE INVENTION

The present invention relates to a board through-hole working method for working a through-hole (for the insertion of a press-fit contact) that is bored in a circuit board and that is formed with a conductor.

In the past, the press-fit contact 101 shown in Figs. 8A, 8B and 8C (see Japanese Patent Application Kokai No. S61-110979), for example, has been used as a contact of a multipole connector that is used in a communication device or the like, and such press-fit contact 101 has been connected to a through-hole formed in a circuit board. Furthermore, it has recently been desired to use the press-fit contact 101, for example, as a contact of a connector to be used for an automobile control unit. The reason for this is that there is no need for solder connection when connecting the press-fit contact 101 to a through-hole formed in a circuit board; therefore, the work of connecting the contact is simplified, and it is possible to avoid any deleterious effects such as wear powder of solder caused by solder connection on the circuits.

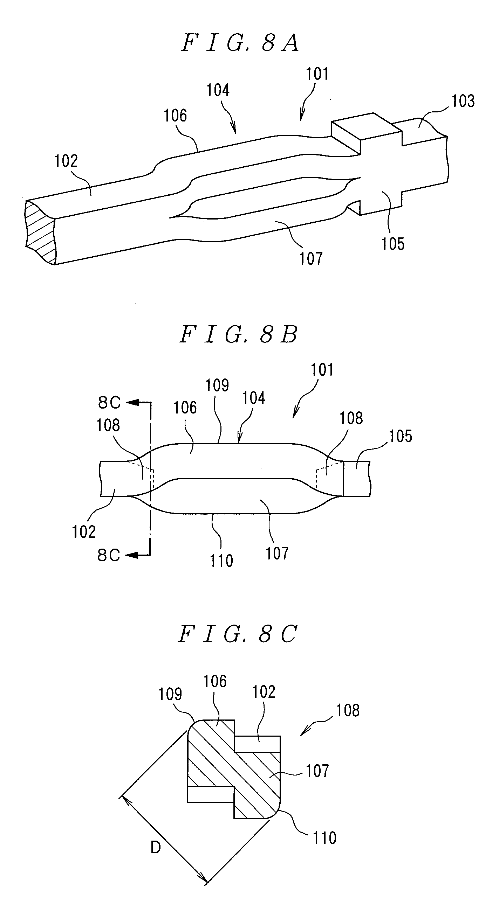

The press-fit contact 101 shown in Figs. 8A, 8B and 8C comprises a first terminal part 102 formed as a supporting column, a second terminal part 103 formed as a supporting column, and an attachment part 104 provided between the first terminal part 102 and the second terminal part 103. A flange part 105 is formed at the border between the second terminal part 103 and the attachment part 104. The press-fit contact 101 is formed by stamping and forming a metal plate, and metal plating such as tin plating is applied to the surface of this contact.

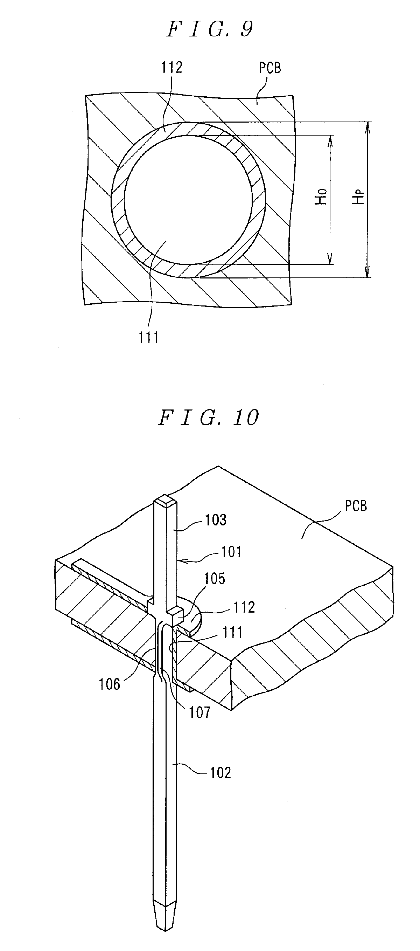

The attachment part 104 is sheared along the vertical axial line of the press-fit contact 101, and has leg parts 106 and 107 that are mutually shifted outward along the sheared surfaces. The leg parts 106 and 107 are formed so that these leg parts extend toward both the first terminal part 102 and the second terminal part 103 parallel to the vertical axial line of the press-fit contact 101 and converge from the areas just before the ends of the sheared surfaces. The leg parts 106 and 107 have gently curved longitudinal outer edge parts 109 and 110. Furthermore, connected parts 108 that are not sheared are formed in the areas where the leg parts 106 and 107 converge. Here, if the distance between the outer edge parts 109 and 110 of the leg parts 106 and 107 at the connected parts 108 is designated as D as shown in Fig. 8C, this distance D is equal to the diameter Hp of the through-hole 111 in a circuit board PCB shown in Fig. 9. Furthermore, a copper film 112 is formed on the inner circumferential surface of the through-hole 111. The diameter Ho of the inner circumference of the copper film 112 is more or less equal to the diameter Hp of the through-hole 111 since the copper film 112 is shown in the figure with its thickness expanded. Moreover, the diameter of the outer edge parts 109 and 110 of the leg parts 106 and 107 is larger than the diameter Hp of the through-hole 111 in the circuit board PCB.

Furthermore, as is shown in Fig. 10, when the leg parts 106 and 107 of the press-fit contact 101 are inserted into the through-hole 111 formed in the circuit board PCB, since the diameter of the outer edge parts 109 and 110 of the leg parts 106 and 107 is larger than the diameter Hp of the through-hole 111, the leg parts 106 and 107 move along the sheared surfaces of the respective other leg parts. At this point, the leg parts 106 and 107 are held inside the through-hole 111 by the elastic contact force of the leg parts 106 and 107 against the inner wall of the through-hole 111, and the press-fit contact 101 is electrically connected to the copper film 112.

However, when the leg parts 106 and 107 of the press-fit contact 101 are inserted into the through-hole 111 formed in the circuit board PCB, the outer edge parts 109 and 110 of the leg parts 106 and 107 (i.e., the outer edge parts 109 and 110 whose diameter is larger than the diameter D of the outer edge parts 109 and 110 at the connected parts 108) contact the corner edge (corner) of the copper film 112 at the insertion opening of the through-hole 111, so that the metal plating applied to these contacted surfaces of the outer edge parts 109 and 110 is stripped away in some cases. When the copper film 112 is made of a copper alloy, then, in particular, the hardness of the film is not only high, but the corner edge of the film is also sharp; therefore, the peeling of the metal plating on the outer edge parts 109 and 110 often occurs.

Accordingly, it is desirable to avoid the contact between the outer edge parts 109 and 110 of the leg parts 106 and 107 and the corner edge of the copper film 112 by giving a bevel to the corner edge of the copper film 112 at the insertion opening of the through-hole 111, thus preventing the metal plating applied to the surfaces of the outer edge parts 109 and 110 from being stripped away.

The through-hole working method disclosed in the past in Japanese Utility Model Registration No. 3084452 is devised such that the corner edge of the inner circumferential surface of a through-hole formed in a circuit board is beveled, and this through-hole is subsequently filled with a conductive member.

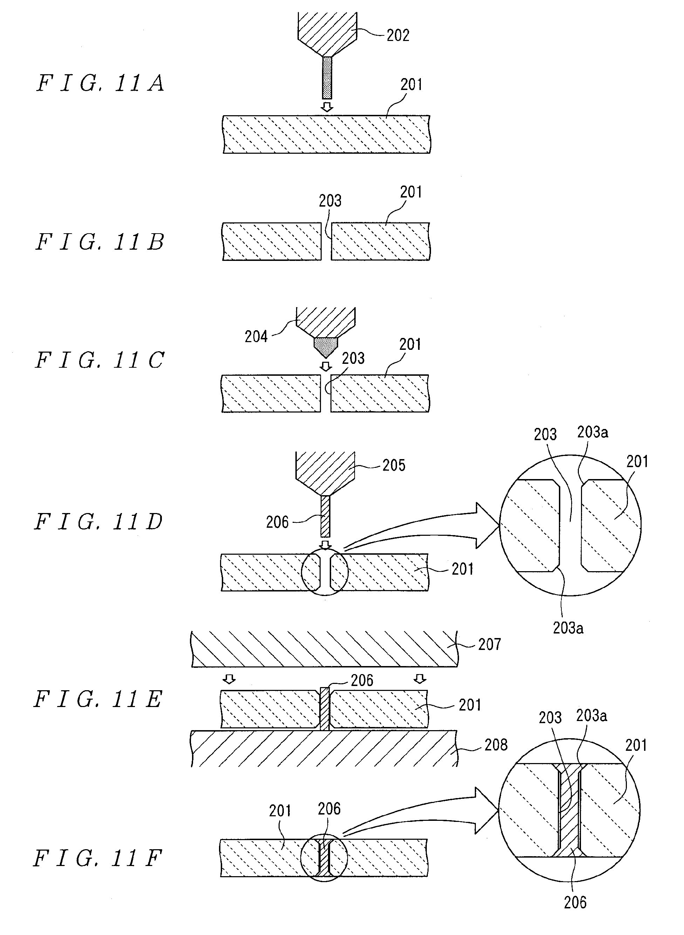

The through-hole working method disclosed in Japanese Utility Model Registration No. 3084452 is shown in Figs. 11A to 11F. A through-hole 203 is first bored in a glass substrate 201 by a drill 202 as shown in Figs. 11A and 11B. Afterward, as is shown in Fig. 11C, a bevel 203a is given to both the upper and lower corner edges of the through-hole 203 by means of a polishing drill 204 such as an electrodeposited diamond drill. Then, as is shown in Fig. 11D, a conductor 206 is supplied to the beveled through-hole 203 by a conductor supply device 205, and is cut at a specified length. Then, as is shown in Figs. 11E and 11F, for the conductor 206 supplied inside the through-hole 203, both end parts of the conductor 206 protruding upward and downward from the glass substrate 201 are pressed by vertically sandwiching the conductor 206 using a jig 207 and a base stand 208 that have flat surfaces. As a result, the conductor 206 is formed into a shape resembling a rivet in which head parts for preventing this conductor from moving back are formed in the opening parts on the top surface and bottom surface of the glass substrate 201, thus fixing the conductor to the through-hole 203.

Furthermore, Japanese Utility Model Application Kokai No. S58-129663 discloses a through-hole working method in which a through-hole to be plated for the attachment of a component is bored by drill cutting or press stamping and subsequently shaped by beveling the surface on the side of the component.

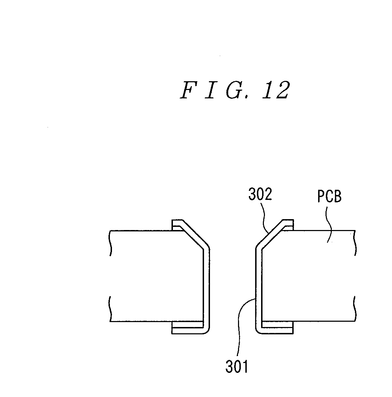

As is shown in Fig. 12, the through-hole working method disclosed in Japanese Utility Model Application Kokai No. S58-129663 is a method in which the shape of a through-hole to be plated 301 that is formed in a circuit board PCB is formed by drill cutting or press stamping, and a bevel 302 is subsequently given to this shape on the side of the component (upper side in Fig. 12).

However, the following problems have been encountered in the through-hole working methods disclosed in Japanese Utility Model Registration No. 3084452 and in Japanese Utility Model Application Kokai No. S58-129663:

Specifically, in the case of the through-hole working method disclosed in Japanese Utility Model Registration No. 3084452, the bevel 203a is given to both the upper and lower corner edges of the through-hole 203 by means of a polishing drill 204 such as an electrodeposited diamond drill. However, since the hard glass substrate 201 itself is treated by the polishing drill 204 in order to form the bevel 203a, there are cases in which the polishing drill 204 is worn away.

Furthermore, in the case of the through-hole working method disclosed in Japanese Utility Model Application Kokai No. S58-129663, there is no disclosure regarding the concrete method for working a through-hole, so that it is questionable whether a plated through-hole can be appropriately beveled, i.e., whether it is possible to perform beveling that prevents the peeling of the metal plating applied to the surfaces of the outer edge parts 109 and 110 of the press-fit contact 101 when the press-fit contact 101 shown in Figs. 8A, 8B and 8C is inserted into the plated through-hole 301. In other words, not only is there no disclosure regarding whether beveling is performed after forming a hole in a circuit board PCB and applying plating to the inner surface of this hole, or plating is applied to the inner surface of a hole after forming the hole in a circuit board PCB and performing beveling, but there is also no disclosure regarding the concrete method for performing beveling, e.g., whether beveling is performed by working a drill or beveling is performed by pressing the corner edge of the through-hole using a jig.

### SUMMARY OF THE INVENTION

Accordingly, the present invention was devised in light of the problems described above; the object of the present invention is to provide a board through-hole working method which makes it possible to form in a circuit board a through-hole that does not strip the metal plating away at the time of the insertion of a press-fit contact, with the amount of wear of a jig minimized.

In order to solve the problems described above, the board through-hole working method of the present invention is a board through-hole working method for working a through-hole (for the insertion of a press-fit contact) that is bored in a circuit board and that is formed with a conductor, wherein the method comprises a step of beveling the corner edge of the through-hole following the formation of the conductor, and this beveling is performed by the pressing of a pointed jig.

In an aspect of the invention, the pointed jig is disposed in a pressing head in a state in which this jig is driven by a spring toward the direction of the corner edge of the through-hole, and this pointed jig is pressed against the corner edge of the through-hole by causing the pressing head to move toward the direction of the corner edge of the through-hole.

In a further aspect of the invention, the pointed jig is fastened to the pressing head, and this pointed jig is pressed against the corner edge of the through-hole by causing the pressing head to move toward the direction of the corner edge of the through-hole.

In another aspect of the invention, cutouts are formed in portions of the outer circumferential surface of the pointed jig, and the jig provided with these cutouts is pressed against the corner edge of the through-hole.

In the board through-hole working method of the present invention, since the method comprises a step of beveling the corner edge of the through-hole following the formation of the conductor, a beveled part is formed on the corner edge of the through-hole, thus making it possible to form in a circuit board a through-hole that does not strip the metal plating away when a press-fit contact is inserted, with the amount of wear of the jig minimized. If the corner edge of the through-hole is beveled prior to the formation of the conductor, there is a danger that the amount of wear of the jig will be increased in cases where the circuit board provided with the through-hole is a hard glass substrate. Furthermore, since the beveling work is performed by pressing the pointed jig, the time required for the beveling work is shortened compared to a case in which the beveling work is performed using a drill or the like.

In an aspect of the invention, the pointed jig is disposed in a pressing head in a state in which this jig is driven by a spring toward the direction of the corner edge of the through-hole, and this pointed jig is pressed against the corner edge of the through-hole by causing the pressing head to move toward the direction of the corner edge of the through-hole. Accordingly, the pressing force of the jig against the corner edge of the through-hole can be made constant, so that the shape of the beveled part formed by beveling can be stabilized.

In a further aspect of the invention, the pointed jig is fastened to the pressing head, and this pointed jig is pressed against the corner edge of the through-hole by causing the pressing head to move toward the direction of the corner edge of the through-hole. Accordingly, it is possible to form a beveled part on the corner edge of the through-hole without using means for applying a spring force to the pointed jig.

In another aspect of the invention, cutouts are formed in portions of the outer circumferential surface of the pointed jig, and the jig provided with these cutouts is pressed against the corner edge of the through-hole. Accordingly, beveled parts are formed on the corner edge of the through-hole by the portions of the jig where no cutout is present, while the corner edge is not pressed by the cutout portions, so that residual parts remain. By setting the positions of the cutouts in the circumferential direction so that these cutouts correspond to the positions of the portions of the press-fit contact in the circumferential direction where the outer edge parts of the leg parts are not formed, beveled parts are formed on the corner edge of the through-hole in positions corresponding to the portions of the press-fit contact where the outer edge parts of the leg parts are formed, leaving the corner edge in positions corresponding to the portions in which the outer edge parts are not formed. Consequently, during the insertion of the press-fit contact, the outer edge parts of the leg parts of the press-fit contact correspond to the beveled parts, thus preventing the contact with the corner edge of the through-hole, so that peeling of the metal plating formed on the surface of the press-fit contact is avoided. Accordingly, by forming the cutouts on the outer circumferential surface of the jig, there is no need to form beveled parts more than necessary, so that a pressing load required to form the beveled parts can be reduced.

### BRIEF DESCRIPTION OF THE DRAWINGS

Fig. 1 is a left-side view showing the through-hole working apparatus used in the board through-hole working method of the present invention;
Fig. 2 is a front view of the through-hole working apparatus shown in Fig. 1;
Fig. 3 is a partial left-side view of essential parts of the through-hole working apparatus shown in Fig. 1;
Fig. 4 is a sectional view of a through-hole worked by the through-hole working apparatus shown in Fig. 1;
Fig. 5 is a partial left-side view showing essential parts of a modified example of the through-hole working apparatus;
Figs. 6A and 6B show modified examples of a jig, with Fig. 6A being a partial front view of the jig, and Fig. 6B being a bottom view of Fig. 6A;
Figs. 7A and 7B show through-holes worked by the pressing of the jig shown in Figs. 6A and 6B, with Fig. 7A being a plan view, and Fig. 7B being a sectional view along line 7B-7B in Fig. 7A;
Figs. 8A, 8B and 8C show common examples of a press-fit contact, with Fig. 8A being a partial perspective view, Fig. 8B being a partial front view, and Fig. 8C being a sectional view along line 8C-8C in Fig. 8B;
Fig. 9 is a plan view of a through-hole formed in a circuit board into which the press-fit contact shown in Figs. 8A, 8B and 8C is inserted;
Fig. 10 is a partial perspective view of a cross-section representing a state in which the press-fit contact shown in Figs. 8A, 8B and 8C is inserted into the through-hole shown in Fig. 9;
Figs. 11A to 11F are explanatory diagrams showing a conventional example of a board through-hole working method; and
Fig. 12 is a sectional view of a through-hole worked by another conventional example of a board through-hole working method.

### DESCRIPTION OF THE PREFERRED EMBODIMENTS

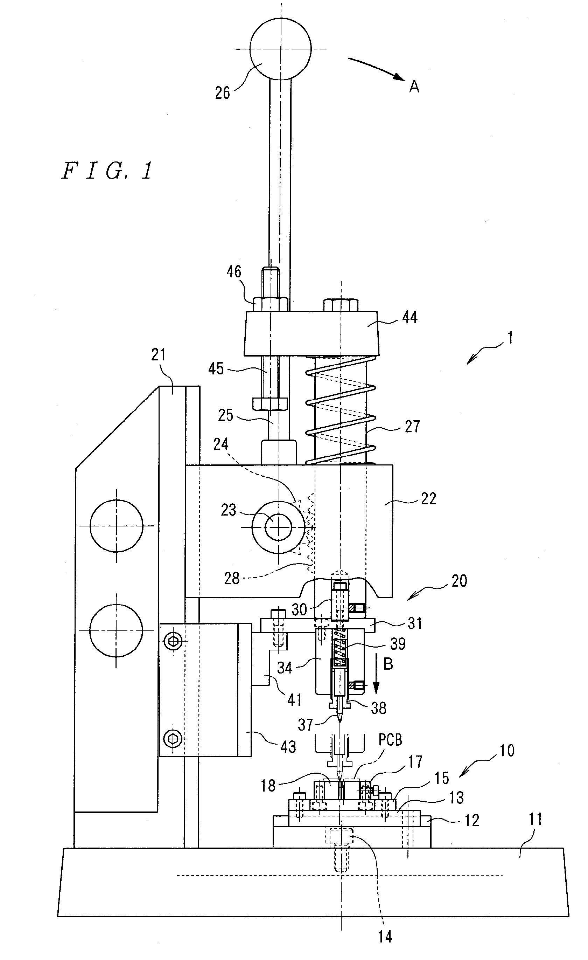

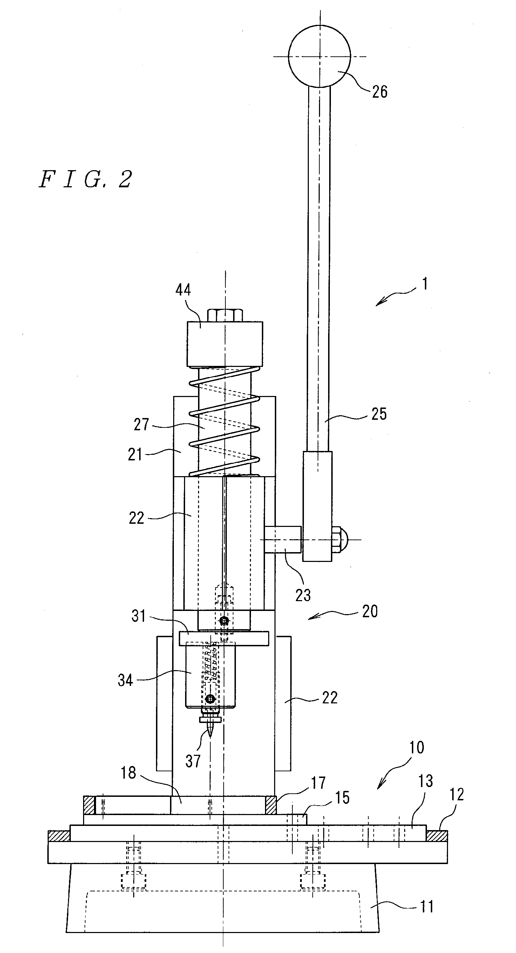

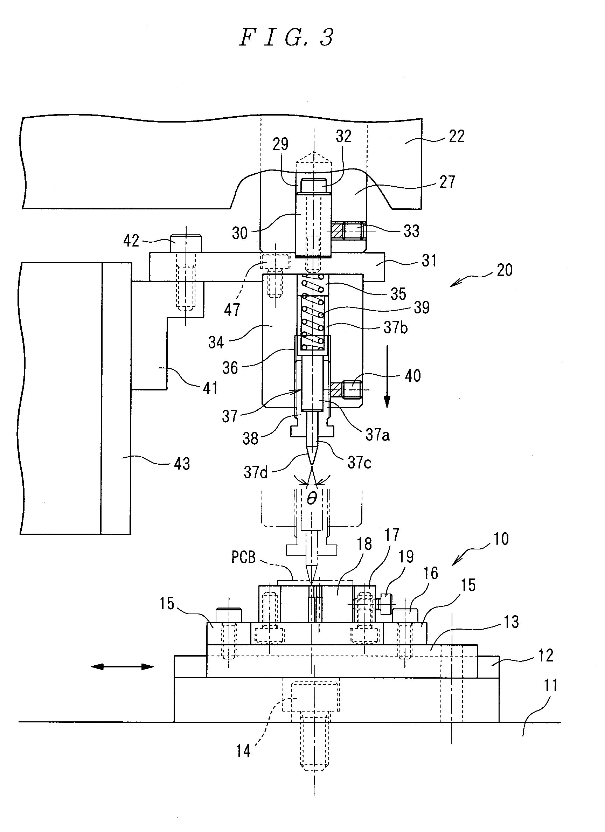

Next, an embodiment of the present invention will be described with reference to the figures. Fig. 1 is a left-side view showing the through-hole working apparatus used in the board through-hole working method of the present invention. Fig. 2 is a front view of the through-hole working apparatus shown in Fig. 1. Fig. 3 is a partial left-side view of essential parts of the through-hole working apparatus shown in Fig. 1.

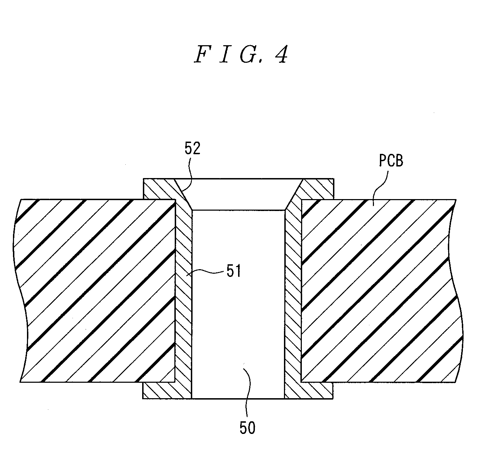

In Figs. 1 through 3, the through-hole working apparatus 1 comprises a positioning part 10 that positions a circuit board PCB and a beveling part 20 that bevels a through-hole 50 (see Fig. 4) formed in the circuit board PCB.

The positioning part 10 comprises a guide rail part 12 that is fastened to the surface of a base frame 11 by a bolt 14 and a base stand 13 that can move along the guide rail part 12 in the arrow direction in Fig. 3 (x direction). Another guide rail part 15 is fastened to the surface of the base stand 13 by bolts 16, and a carrying stand supporting part 17 is installed thereon, which can move along the guide rail part 15 in a direction (y direction) perpendicular to the arrow direction in Fig. 3. A board carrying stand 18 is attached by bolts 19 to the carrying stand supporting part 17. Furthermore, a circuit board PCB is placed on the board carrying stand 18. The positioning of the circuit board PCB in the x and y directions is accomplished by positioning the base stand 13 in the x direction and positioning the board carrying stand 18 in the y direction.

Moreover, the beveling part 20 comprises a supporting part 21 that is installed upright on the base frame 11. A ram supporting part 22 is provided slightly upward in the vertical direction of the supporting part 21. A rotating shaft 23 equipped with a pinion gear 24 is provided on the ram supporting part 22 so that this shaft can be rotated, and a handle shaft 25 is attached to one end of the rotating shaft 23. An operating part 26 is attached to the tip end of the handle shaft 25. Furthermore, a ram 27 is provided to the ram supporting part 22 so that this ram 27 is free to move upward and downward with respect to the ram supporting part 22. A rack 28 that meshes with the pinion gear 24 is provided on a portion of the outer circumference of the ram 27.

Furthermore, a hole 29 is bored in the lower end portion of the ram 27, and an attachment shaft 30 is disposed inside the hole 29. The attachment shaft 30 is fastened to the ram 27 by a screw member 33. Moreover, a pressing head supporting plate 31 is disposed beneath the attachment shaft 30. The pressing head supporting plate 31 is fastened to the attachment shaft 30 by a bolt 32. A pressing head 34 is disposed beneath the pressing head supporting plate 31, and the pressing head 34 is fastened to the pressing head supporting plate 31 by a bolt 47. A through-hole 35 that passes through in the vertical direction is bored in the pressing head 34, and a female screw part 36 is formed in the lower portion of the through-hole 35. Furthermore, a pointed jig 37 is disposed inside the through-hole 35 so that this jig can move up and down, and the downward movement of the jig 37 is restricted by a hollow cylindrical jig supporting member 38 that engages with the female screw part 36. The jig supporting member 38 is prevented from rotating by a screw member 40.

The jig 37 comprises a shaft part 37a that is accommodated inside the jig supporting member 38, a tubular part having a bottom 37b that extends upward from the shaft part 37a, and a pointed pressing part 37c that extends downward from the shaft part 37a, all of which are integrally constructed. The material of the jig 37 is ordinary tool steel. The external diameter of the tubular part having a bottom 37b is larger than the external diameter of the shaft part 37a, and the downward movement of the jig 37 is restricted by the shoulder part that is formed at the lower end of the tubular part having a bottom 37b sitting on the jig supporting member 38. A compression spring 39 whose upper end contacts the undersurface of the pressing head supporting plate 31 and whose lower end contacts the bottom part of the tubular part having bottom 37b is inside the tubular part having bottom 37b, and the jig 37 is driven downward (in the direction of the corner edge of the through-hole 50) by this compression spring 39. The external diameter of the pressing part 37c is smaller than the external diameter of the shaft part 37a, and a pointed corner edge pressing part 37d that presses the corner edge of the through-hole 50 formed in the circuit board PCB is formed at the lower end of the pressing part 37c. It is preferred that the angle θ formed by the ridgeline of the corner edge pressing part 37d is 30° to 90°. The reason for this is that if this angle θ is smaller than 30°, the angle is too sharp to form a beveled part 52 in an appropriate shape (see Fig. 4). Furthermore, if the angle θ is larger than 90°, the beveled part 52 cannot be formed in an appropriate shape, either.

Moreover, a rotation stopping member 41 for preventing rotation of the ram 27 and pressing head 34 is attached to the pressing head supporting plate 31 by a bolt 42. The rotation stopping member 41 prevents the ram 27 and pressing head 34 from rotating by contacting a rotation stopping part 43 provided on the supporting part 21.

Meanwhile, a stopper attachment member 44 is fastened to the upper end portion of the ram 27, and a stopper bolt 45 that restricts the downward movement of the ram 27 is attached to the stopper attachment member 44 by a nut 46. The stopper bolt 45 restricts the downward movement of the ram 27 by contacting the upper end surface of the ram supporting part 22 when the ram 27 moves downward. The position of the stopper bolt 45 in the vertical direction is made adjustable.

A method for beveling the through-hole 50 formed in the circuit board PCB using the through-hole working apparatus 1 constructed as described above will be described with reference to Figs. 1 through 4. Fig. 4 is a sectional view of the through-hole 50 formed in the circuit board PCB.

Prior to the beveling work described above, a conductor 51 is formed on the inner wall surface of the through-hole 50 bored in the circuit board PCB. Furthermore, the circuit board PCB containing the through-hole 50 having the conductor 51 formed on the inner wall surface thereof is placed on the board carrying stand 18, and the positioning of the circuit board PCB in the x and y directions is performed by the positioning part 10.

Next, the operating part 26 of the beveling part 20 is rotated in the arrow direction A in Fig. 1, so that the ram 27 and pressing head 34 are lowered in the arrow direction B (i.e., in the direction of the corner edge of the conductor 51 formed on the through-hole 50) via the pinion gear 24 and rack 28. The operating part 26 is rotated until the stopper bolt 45 contacts the upper end surface of the ram supporting part 22. As a result, the corner edge pressing part 37d of the jig 37 presses the upper corner edge of the conductor 51 formed on the through-hole 50, so that the beveled part 52 is formed on the corner edge. Accordingly, during the insertion of the press-fit contact 101 (see Figs. 8A, 8B and 8C), the outer edge parts 109 and 110 of the leg parts 106 and 107 of the press-fit contact 101 are prevented from contacting the upper corner edge of the conductor 51, so that peeling of the metal plating formed on the surface of the press-fit contact 101 is avoided. It has been confirmed through experiments that the peeling of the metal plating on the surface of the press-fit contact 101 does not occur in cases where the diameter of the beveled part 52 at the upper end is equal to or larger than the maximum diameter of the attachment part 104 of the press-fit contact 101 (i.e., the diameter of the outer edge parts 109 and 110 of the leg parts 106 and 107).

If the corner edge of the through-hole 50 is beveled prior to the formation of the conductor 51, there is a danger that the amount of wear of the jig 37 will increase in cases where the circuit board PCB in which the through-hole 50 is bored is a hard glass substrate. In contrast, since the beveled part 52 is formed on the upper corner edge of the conductor 51 on the through-hole 50 following the formation of the conductor 51 on the inner wall surface of the through-hole 50, the through-hole 50 that does not strip the metal plating away during the insertion of the press-fit contact 101 (see Figs. 8A, 8B and 8C) can be formed in the circuit board PCB, with the amount of wear of the jig 37 minimized. Furthermore, since beveling is performed by the pressing of the pointed jig 37, the time required for the beveling work can be shortened compared to a case in which beveling is performed by means of a drill or the like.

Moreover, in the step, in which the corner edge pressing part 37d of the jig 37 presses the corner edge of the conductor 51 formed on the through-hole 50 in the circuit board PCB, the jig 37 is spring driven toward the direction of the corner edge of the through-hole 50 while receiving an upward force from below (from the circuit board PCB toward the jig 37). Accordingly, the pressing force of the jig 37 against the corner edge of the through-hole 50 can be made constant. As a result, the shape of the beveled part 52 formed by this beveling work can be stabilized.

Furthermore, the circuit board PCB that has completed the beveling of the through-hole 50 is removed from the board carrying stand 18, and this circuit board PCB is sent to the subsequent step.

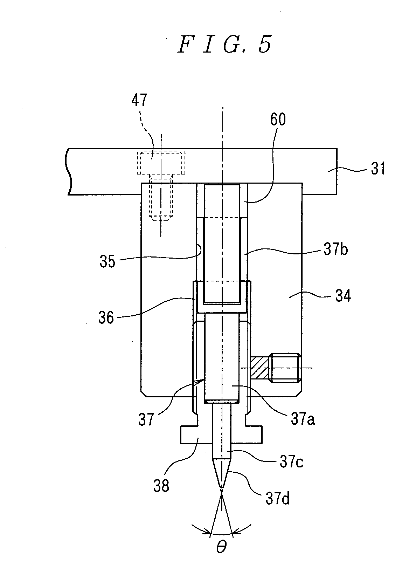

Furthermore, instead of providing the interior of the tubular part having a bottom 37b with the compression spring 39, as is shown in Fig. 5, it would also be possible to form a tubular fastening collar 60 between the tubular part having a bottom 37b of the jig 37 and the pressing head supporting plate 31 inside the through-hole 35 in the pressing head 34, thus fastening the jig 37 to the pressing head 34 with this collar. In this way as well, it is possible to form the beveled part 52 on the upper corner edge of the conductor 51 of the through-hole 50. In this case, furthermore, since the compression spring 39 is not needed, the size of the pressing head 34 can be reduced, making the pressing head suitable in cases where numerous through-holes 50 formed in the circuit board PCB are worked; for example, it will be possible to simultaneously work a plurality of through-holes 50 by arranging pressing heads 34 at the same pitch as the array pitch of the through-holes 50.

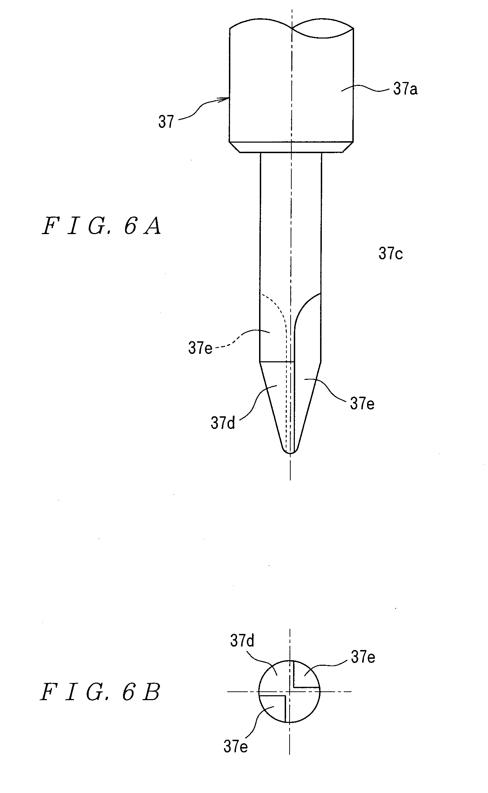

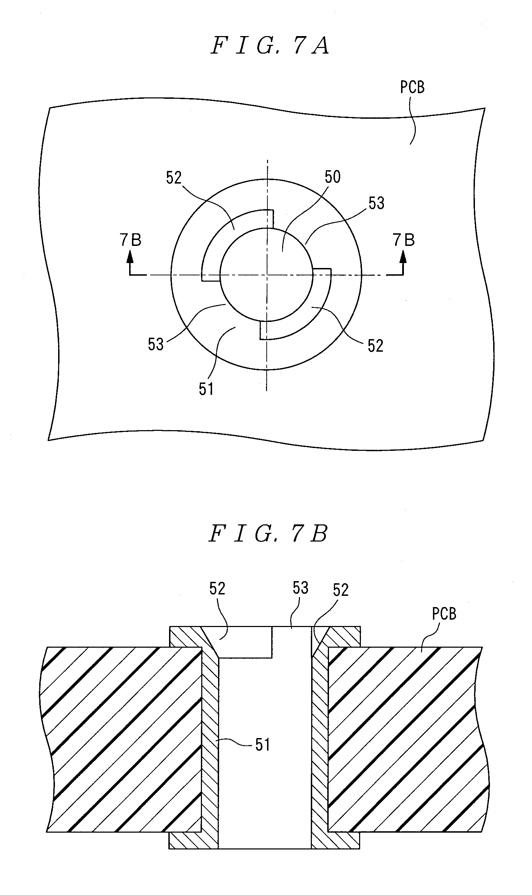

Furthermore, as is shown in Figs. 6A and 6B, with regard to the shape of the pointed jig 37, it is also possible to form a pair of cutouts 37e from the outer circumferential surface of the pressing part 37c toward the tip end of the outer circumferential surface of the corner edge pressing part 37d. The positions of these cutouts 37e in the circumferential direction are such that these cutouts face each other to correspond to the positions of the portions of the press-fit contact 101 shown in Figs. 8A, 8B and 8C in the circumferential direction where the outer edge parts 109 and 110 of the leg parts 106 and 107 are not formed (see Figs. 6B and 8C). Accordingly, when the upper corner edge of the conductor 51 formed on the through-hole 50 is pressed using the jig 37 shown in Figs. 6A and 6B, beveled parts 52 are formed on the upper corner edge of the conductor 51 as shown in Figs. 7A and 7B by the portions of the corner edge pressing part 37d where the cutouts 37e are absent. On the other hand, the corner edge is not pressed by the portions of the cutouts 37e, so that residual parts 53 remain. At the time of the insertion of the press-fit contact 101, the outer edge parts 109 and 110 of the leg parts 106 and 107 of the press-fit contact 101 correspond to the beveled parts 52, thus preventing the contact with the corner edge of the conductor 51, so that peeling of the metal plating formed on the surface of the press-fit contact 101 is avoided. Accordingly, by forming the cutouts 37e on the outer circumferential surface of the jig 37, there is no need to form beveled parts 52 more than necessary, so that a pressing load required to form the beveled parts 52 can be reduced. Consequently, working characteristics using a manual through-hole working apparatus 1 are improved. Furthermore, it is still preferable to set the angle θ formed by the ridgeline of the corner edge pressing part 37d at 30° to 90°.

An embodiment of the present invention was described above. However, the present invention is not limited to this embodiment; various alterations and modifications can be made.

For example, the beveled parts 52 are formed with portions of the conductor 51 remaining as shown in Figs. 4, 5, 6A and 6B, and 7A and 7B, but it would also be possible to perform beveling so that beveled parts are formed on the corner edge of the circuit board PCB as well.

Moreover, the beveled parts 52 are formed on the upper corner edge of the conductor 51 as shown in Figs. 4, 5, 6A and 6B, and 7A and 7B, but it would also be possible to form the beveled parts on both the upper and lower corner edges of the conductor 51.

## Claims

1. A board through-hole working method for working a through-hole that is bored in a circuit board (PCB) and that is formed with a conductor (51) for the insertion of a press-fit contact,
wherein the method comprises a step of beveling a corner edge of the through-hole (50) following the formation of the conductor (51), and this beveling is performed by pressing a pointed jig (37) against the corner edge of the through-hole (50).

2. The board through-hole working method according to Claim 1, wherein the pointed jig (37) is disposed in a pressing head (34) in a state in which this pointed jig (37) is driven by a spring (39) toward the direction of the corner edge of the through-hole (50), and this pointed jig (37) is pressed against the corner edge of the through-hole (50) by causing the pressing head (34) to move toward the direction of the corner edge of the through-hole (50).

3. The board through-hole working method according to Claim 1, wherein the pointed jig (37) is fastened to the pressing head (34), and this pointed jig (37) is pressed against the corner edge of the through-hole (50) by causing the pressing head (34) to move toward the direction of the corner edge of the through-hole (50).

4. The board through-hole working method according to any one of Claims 1 to 3, wherein cutouts (37e) are formed in portions of an outer circumferential surface of the pointed jig (37), and the pointed jig (37) provided with these cutouts (37e) is pressed against the corner edge of the through-hole (50).
